(19) Europäisches Patentamt
European Patent Office
Office européen des brevets

(11) **EP 3 228 006 B1**

(12) **EUROPÄISCHE PATENTSCHRIFT**

(45) Veröffentlichungstag und Bekanntmachung des Hinweises auf die Patenterteilung:
**22.09.2021 Patentblatt 2021/38**

(21) Anmeldenummer: **15780896.5**

(22) Anmeldetag: **15.10.2015**

(51) Int Cl.:
*H03H 9/00* (2006.01)    *H03H 9/64* (2006.01)
*H03H 9/145* (2006.01)

(86) Internationale Anmeldenummer:
**PCT/EP2015/073903**

(87) Internationale Veröffentlichungsnummer:
**WO 2016/087106 (09.06.2016 Gazette 2016/23)**

(54) **ANORDNUNG MIT EINEM DMS FILTER UND STEILER RECHTER FLANKE**

ARRANGEMENT COMPRISING A DMS FILTER AND A STEEP RIGHT EDGE

DISPOSITIF AVEC FILTRE DMS ET FLANC DROIT RAIDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.12.2014 DE 102014118000**

(43) Veröffentlichungstag der Anmeldung:
**11.10.2017 Patentblatt 2017/41**

(73) Patentinhaber: **SnapTrack, Inc.**
**San Diego, CA 92121 (US)**

(72) Erfinder: **BERGMANN, Andreas**
**84533 Haiming (DE)**

(74) Vertreter: **Bardehle Pagenberg Partnerschaft mbB**
**Patentanwälte Rechtsanwälte**
**Prinzregentenplatz 7**
**81675 München (DE)**

(56) Entgegenhaltungen:
EP-A2- 1 710 910        JP-A- H09 148 873
US-A1- 2013 109 332

• **HEEP L W ED - MCAVOY B R: "SELECTIVE NULL PLACEMENT IN SAW COUPLED RESONATOR FILTERS", PROCEEDINGS OF THE ULTRASONICS SYMPOSIUM. LAKE BUENA VISTA, DEC. 8 - 11, 1991; [PROCEEDINGS OF THE ULTRASONICS SYMPOSIUM], NEW YORK, IEEE, US, Bd. 1, 8. Dezember 1991 (1991-12-08), Seiten 185-188, XP000347148,**

• **KOVACS G ET AL: "DMS filter with reduced resistive losses", 2004 IEEE ULTRASONICS SYMPOSIUM : 23 - 27 AUGUST 2004, PALAIS DES CONGR GBP ES, MONTRÉAL, CANADA, IEEE OPERATIONS CENTER, PISCATAWAY, NJ, Bd. 1, 23. August 2004 (2004-08-23), Seiten 294-297, XP010784093, DOI: 10.1109/ULTSYM.2004.1417724 ISBN: 978-0-7803-8412-5**

• **LIU JIULING ET AL: "SAW antenna duplexer for trunking communication", 2004 IEEE ULTRASONICS SYMPOSIUM : 23 - 27 AUGUST 2004, PALAIS DES CONGR GBP ES, MONTRÉAL, CANADA, IEEE OPERATIONS CENTER, PISCATAWAY, NJ, Bd. 2, 23. August 2004 (2004-08-23), Seiten 1521-1524, XP010784252, ISBN: 978-0-7803-8412-5**

• **SHARIF M A ET AL: "Coupled resonator filters with differential input and/or differential output", ULTRASONICS SYMPOSIUM, 1995. PROCEEDINGS., 1995 IEEE SEATTLE, WA, USA 7-10 NOV. 1995, NEW YORK, NY, USA,IEEE, US, Bd. 1, 7. November 1995 (1995-11-07), Seiten 67-70, XP010157288, DOI: 10.1109/ULTSYM.1995.495542 ISBN: 978-0-7803-2940-9**

• **WEIBIAO WANG ET AL: "High selectivity SAW DMS filter with in-between shorted-gratings", ULTRASONICS SYMPOSIUM (IUS), 2010 IEEE, IEEE, 11. Oktober 2010 (2010-10-11), Seiten 1263-1266, XP031952715, DOI: 10.1109/ULTSYM.2010.5935578 ISBN: 978-1-4577-0382-9**

EP 3 228 006 B1

**Beschreibung**

Die Erfindung betrifft eine Filteranordnung, die ein DMS Filter umfasst und eine Filterfunktion mit steiler rechter Flanke aufweist.

Bandpassfilter für moderne Kommunikationsstandards wie beispielsweise LTE müssen hohe Anforderungen bezüglich Bandbreite und Flankensteilheit erfüllen. Es existieren Bänder mit hoher Bandbreite und niedrigem Abstand zu benachbarten Bändern, gegenüber denen die dafür verwendeten Filter eine ausreichend hohe Dämpfung aufweisen müssen. Dies kann nur mit steilen Flanken erreicht werden.

Verlustarme Filter mit hoher Bandbreite können als DMS-Filter realisiert werden. DMS-Filter haben jedoch den Nachteil, dass die obere Flanke des Passbands nur sehr flach abfällt und gegenüber einem im oberen Frequenzbereich benachbarten Band nur eine geringe Trennschärfe aufweist. Die Nahselektion ist daher mäßig.

Für breitbandige Filter müssen hochkoppelnde piezoelektrische Substratmaterialien eingesetzt werden. Mit größerer Kopplung erhält man jedoch auch einen vergrößerten Pol-Nullstellen-Abstand bei Eintor-Resonatoren, deren Einsatz zumindest bei Sendefiltern unerlässlich ist. Der vergrößerte Pol-Nullstellen-Abstand führt dann wiederum zu einer größeren Übergangsbandbreite und mithin zu einer relativ geringen Flankensteilheit. Diese erfüllt zum Teil die Anforderungen für das jeweilige Kommunikationssystem nicht.

Verschaltet man eine Kapazität parallel zu Eintor-Resonatoren und diese wiederum mit einem DMS-Filter, so lässt sich dadurch zwar der Pol-Nullstellen-Abstand der für die obere Flanke verantwortlichen Eintor-Resonatoren verringern. Allerdings leiden darunter auch die Güten der so modifizierten Resonatoren im Vergleich zu den Resonatoren ohne parallel geschaltete Kapazität. Dies wiederum hat eine vergrößerte Einfügedämpfung, insbesondere an der oberen Kante des Durchlassbereichs, zur Folge.

Es wurden verschiedene Anstrengungen zur Lösung dieses Problems unternommen, die jedoch allesamt wiederum neue Nachteile aufweisen und daher entweder aus technischen oder wirtschaftlichen Gründen nicht einsetzbar sind. Siehe hierzu auch JP09148873.

Aufgabe der vorliegenden Erfindung ist es daher, eine Anordnung mit einem DMS-Filter, also eine Filteranordnung, anzugeben, die im nahen oberen Sperrbereich eine deutlich höhere Selektion aufweist, als dies bekannte DMS-Filter bieten. Eine weitere Aufgabe ist es, die Bandbreite solcher Filter ausreichend hoch einzustellen.

Diese Aufgabe wird erfindungsgemäß durch eine Anordnung nach Anspruch 1 gelöst. Vorteilhafte Ausgestaltungen der Erfindung sind weiteren Ansprüchen zu entnehmen.

Es wird eine Anordnung mit einem neuartigen DMS-Filter angegeben. Das DMS-Filter weist erste und zweite Wandler auf, die insbesondere alternierend auf einem piezoelektrischen Substrat zwischen zwei Reflektoren angeordnet sind. Die ersten Wandler sind mit einem Ein- oder Ausgang der Anordnung gekoppelt, die zweiten Wandler mit dem jeweils anderen aus Aus- oder Eingang der Anordnung.

Im Vergleich zu einem bekannten DMS-Filter ist im erfindungsgemäßen DMS-Filter zumindest einer der Wandler eines Typs, ausgewählt aus erstem oder zweitem Wandler, vorzugsweise aber alle Wandler eines Typs symmetrisch in zwei elektrisch parallel geschaltete Teilwandler geteilt. Die beiden Teilwandler sind nun gegenüber ihrer ursprünglichen Lage im ungeteilten Wandler etwas weniger als eine halbe Wellenlänge $\lambda$ plus n mal $\lambda$ auseinandergerückt, wobei n eine ganze Zahl größer gleich Null ist (0, 1, 2 usw.). Damit kann die Differenz D zur bekannten Anordnung einen Wert von z.B.

$$D = 0,5\lambda - d + n\lambda$$

annehmen, wobei $0 < d < 0,2\lambda$. Der Abstand zwischen den beiden Teilwandlern, der nun nicht mehr dem Fingerabstand im ursprünglichen Wandler entspricht, wird dabei so bemessen, dass sich die von den beiden Teilwandlern erzeugten akustischen bzw. elektrischen Signale bei einer Frequenz im Stoppband gegenseitig auslöschen. Bei dieser Frequenz wird dann in der Übertragungsfunktion eine Nullstelle erzeugt. Im Folgenden wird der in zwei Teilwandler aufgespaltene Wandler noch immer als ein Wandler (mit zwei Hälften oder zwei Teilwandlern) bezeichnet, unabhängig davon, ob dazwischen noch andere Elemente des Filters wie z.B. Reflektorstreifen angeordnet sind.

Durch geeignete Positionierung dieser Nullstelle wird die rechte Flanke gegenüber einem bekannten DMS-Filter deutlich versteilert, ohne dass dadurch die anderen Filtereigenschaften in Mitleidenschaft gezogen werden. Das DMS-Filter ist insbesondere bezüglich der Wandler symmetrisch aufgebaut und weist bezüglich der Anordnung der einzelnen Wandler eine Achsensymmetrie auf, deren Spiegelachse durch einen der Wandler oder durch die Mitte zwischen den beiden Teilwandlern verläuft. Dies führt dazu, dass das DMS-Filter eine ungerade Anzahl von Wandlern aufweist. Durch die alternierende Anordnung von ersten und zweiten Wandlern entlang der Ausbreitungsrichtung der akustischen Welle im DMS-Filter wird auch eine hohe Symmetrie der einzelnen Signalanteile erzielt, mit der eine exakte Übertragungsfunktion gesichert werden kann.

Das DMS-Filter kann dabei elektrisch beidseitig single-ended angeschlossen werden. Möglich ist es jedoch auch, zumindest eine der Seiten aus Eingang und Ausgang mit symmetrischer Signalverarbeitung zu betreiben und so einen balanced Ein- oder Ausgang der Filteranordnung zu schaffen.

Das verbesserte DMS-Filter und damit die verbesserte Anordnung mit dem neuen DMS-Filter zeichnet sich dadurch aus, dass sie ohne zusätzlichen Aufwand hergestellt werden kann und lediglich eine etwas höhere Wandlerlänge gegenüber dem bekannten DMS-Filter aufweist, die aber bezüglich der Gesamtfläche praktisch nicht ins Gewicht fällt. Es sind auch keine weiteren Kompensationsmaßnahmen erforderlich, um das Filter bzw. die Anordnung mi dem neuen DMS Filter zu betreiben. Es ist nur die Anzahl der Finger in den Teilwandlern erhöht. Die Erhöhung der Fingerzahl in den aufgespalteten Wandlern ist umso größer, je näher die durch die Aufspaltung erzeugte Übertragungsnullstelle an der oberen Bandkante liegt. Die Gesamtanzahl der Elektrodenfinger in den beiden Teilwandlern ist größer als die Summe der Elektrodenfinger im ungeteilten Wandler des entsprechenden bekannten Filters.

Gemäß der Erfindung sind die beiden Teilwandler so weit auseinandergerückt, dass der Abstand zwischen den beiden Teilwandlern, der zwischen den einander zugewandten Außenkanten der jeweils endständigen Elektrodenfinger der Teilwandler gemessen wird, mehr als eine Wellenlänge beträgt. Es zeigt sich, dass mit einem größer werdenden freien Abstand der beiden Teilwandler eine schärfere Resonanz erhalten wird. Mit einem solchen wiederum wird die obere Flanke des Passbands weiter versteilert. Insgesamt wird die Frequenz dieser zusätzlichen Resonanz aus den von den beiden Teilwandlern erzeugten Signalen durch geeignete Bemessung des Abstands so gelegt, dass die Resonanz nahe der oberen Kante des Passbands zu liegen kommt, die Antiresonanz dagegen außerhalb, aber nahe dem Passband.

Ein größer werdender freier Abstand zwischen den beiden Teilwandlern führt bei Anwendung der Erfindung auf Leckwellensubstraten dazu, dass ein Teil der akustischen Welle in das Substrat abtaucht und für die Signalverarbeitung nicht mehr zur Verfügung steht. Um die akustische Welle auf Leckwellensubstraten nahe der Oberfläche zu führen, ist es daher vorteilhaft, eine Metallisierung im freien Abstand zwischen den beiden Teilwandlern auf der Substratoberfläche aufzubringen. Vorzugsweise wird eine Metallisierung so aufgebracht, dass sich die Metallisierungsstärke über den Wandler bzw. die beiden Teilwandler hinweg nicht zu stark ändert, um keine Unstetigkeiten zu erzeugen. Eine geeignete Metallisierung besteht daher in einem Streifenmuster, also einer Anordnung von zueinander parallelen Streifen, deren Abstand ähnlich dem der Elektrodenfinger in den Teilwandlern gewählt wird.

Das DMS-Filter zeichnet sich durch zumindest einen in Teilwandler aufgeteilten Wandler aus. Gemäß einer Ausführungsform sind jedoch zwei und mehr Wandler eines Typs, ausgewählt aus erstem und zweitem Wandler, in gleicher oder ähnlicher Weise in Teilwandler aufgeteilt.

Gemäß einer Ausführung sind alle Wandler eines Typs in Teilwandler aufgeteilt. Sind nicht alle Wandler in Teilwandler aufgeteilt, so erfolgt die Aufteilung symmetrisch, um die guten Filtereigenschaften nicht zu gefährden. Das heißt, dass die geteilten Wandler symmetrisch im Filter verteilt sind.

In einer vorteilhaften Ausgestaltung der Erfindung ist das Filter für einen unsymmetrischen Betrieb wieder symmetrisch aufgebaut und weist eine ungerade Gesamtanzahl an ersten und zweiten Wandlern auf. Aufgrund der Symmetrie und der alternierenden Anordnung von ersten und zweiten Wandlern werden die beiden im DMS-Filter äußeren Wandler von dem Wandlertyp gebildet, von dem die größere Anzahl im DMS-Filter vorhanden ist. Wandler eines Typs werden in Teilwandler aufgeteilt. Dies können einzelne Wandler sein. Vorzugsweise werden alle Wandler dieses Typs aufgeteilt. Möglich ist es auch, alle Wandler bis auf die beiden genannten, im DMS-Filter äußeren Wandler aufzuteilen.

Durch ein geeignetes Design des DMS-Filters können auch die Signale dieser beiden äußeren Wandler dazu genutzt werden, einen zusätzlichen Dämpfungspol, der einer zusätzlichen Antiresonanz zugeordnet ist, zu erzeugen. Dies wird erfindungsgemäß durch einen geeignet gewählten Abstand der jeweiligen äußeren Wandler dieses Typs zum benachbarten Reflektor erreicht. Mithin wird hier die Antiresonanz durch Wechselwirkung der Wandlersignale des jeweils äußeren Wandlers mit den vom Reflektor reflektierten Signalen gebildet.

Gemäß einer Ausführungsform enthält eine erfindungsgemäße Anordnung neben dem DMS-Filter zumindest einen in Serie zum DMS-Filter geschalteten Serienresonator und einen parallel dazu geschalteten Parallelresonator.

Mit den beiden Resonatoren, die vorteilhaft mit dem Eingang der Filteranordnung verbunden sind, wird eine verbesserte Leistungsbeständigkeit der Anordnung erzielt. Werden die Resonanzfrequenzen der Resonatoren geeignet gewählt, so können diese außerdem zur Formung des Passbands und zur weiteren Schärfung bzw. Versteilerung der oberen Passbandflanke eingesetzt werden.

Die Anordnung kann weitere Resonatoren umfassen, die in Serie oder parallel zum DMS-Filter geschaltet sind. Die weiteren Resonatoren können ein oder mehrere Grundglieder einer Laddertype-Struktur ausbilden, also für sich ein Reaktanzfilter darstellen.

In einer Ausgestaltung umfasst die Filteranordnung je eine Spule, die mit Ein- und Ausgang der Anordnung in Serie geschaltet ist. Mit diesen Anschlussspulen wird eine Impedanztransformation bewirkt. Für diesen Zweck können Spulen auch parallel zum Filterein- oder ausgang geschaltet werden.

Gemäß einer Ausführung wird eine Kapazität parallel zu einem Resonator geschaltet, um dessen Pol-Nullstellen-Abstand zu reduzieren. Auf diese Weise gelingt es, eine schärfere Resonanz zu erzeugen, womit sich ebenfalls die obere Flanke steiler gestalten lässt. Vorzugsweise werden zumindest parallel zu den Serienresonatoren Kapazitäten geschaltet. Möglich ist es jedoch auch, Kapazitäten parallel zu sämtlichen Resonatoren zu schalten, die mit der Anordnung verschaltet sind.

Dabei ist es weiterhin vorteilhaft, wenn die Pol-Nullstellen-Abstände für die in der Anordnung eingesetzten Resonatoren unterschiedlich gewählt werden. Dies kann dadurch erfolgen, dass in jedem der Resonatoren zumindest ein Bandbreitenmittel eingesetzt wird, mit dessen Hilfe der Pol-Nullstellen-Abstand verändert und so für verschiedene Resonatoren unterschiedlich gestaltet werden kann.

Als Bandbreitenmittel können beispielsweise die Werte der parallel zu den Resonatoren geschalteten Kapazitäten unterschiedlich gewählt werden. Möglich ist es auch, die Höhe einer Kompensationsschicht, die auf dem Filter zur Verminderung des Temperaturkoeffizienten der Frequenz aufgebracht ist, unterschiedlich einzustellen. Besonders einfach kann die Höhe einer die Filteranordnung abdeckenden $SiO_2$-Schicht variiert werden.

Die Parallelresonatoren der Anordnung sind jeweils in Parallelzweigen angeordnet, die eine serielle Signalleitung mit einem Masseanschluss verbinden. Die Parallelzweige können mit dem Masseanschluss über eine Serieninduktivität verbunden sein. Möglich ist es, jeden Parallelzweig mit einer separaten Serieninduktivität mit dem Masseanschluss zu verbinden. Alternativ können auch mehrere Parallelzweige masseseitig zusammengefasst und über eine gemeinsame Serieninduktivität mit dem Masseanschluss verbunden werden.

In einer weiteren Ausführung ist die Metallisierung, die die Teilwandler trennt, als ein elektrisch floatendes oder als elektrisch kurzgeschlossenes Streifenmuster ausgebildet. Dieses dient dazu, den Verlauf der Metallisierungsstärke über die Länge des Wandlers möglichst ohne Unstetigkeit zu gestalten. Zu diesem Zweck ist es vorteilhaft, Fingerabstände, Fingerbreiten und den von Fingermitte zu Fingermitte bemessenen Pitch im Bereich des Übergangs von einem Wandler zum benachbarten Wandler oder von einem Wandler zum Reflektor oder von einem Wandler zur als Streifenmuster ausgebildeten Metallisierung zu verändern und insbesondere zu verringern. Dabei werden bis zu n endständige Elektrodenfinger bezüglich Breite und/oder Abstand variiert, um die Veränderungen dieser Parameter von Finger zu Finger möglichst gering zu gestalten. Vorzugsweise wird die Anzahl n der diesbezüglich veränderten Elektrodenfinger, Reflektorstreifen oder Streifen des Streifenmusters auf einen Wert zwischen 3 und 12 gewählt. n ist vorzugsweise umso größer, je stärker der Abstand der endständigen Finger ohne diese Variation von einem Vielfachen von A/2 abweicht.

Im Folgenden wird die Erfindung anhand von Ausführungsbeispielen und den dazugehörigen Figuren näher erläutert. Die Figuren sind nur schematisch und nicht maßstabsgetreu ausgebildet. Die Strukturen sind vereinfacht dargestellt und den Figuren lassen sich weder relative noch absolute Größenangaben entnehmen. Gleiche oder gleich wirkende Teile sind mit gleichen Bezugszeichen bezeichnet.

Es zeigen:

Figur 1 ein an sich bekanntes DMS-Filter mit drei Wandlern,

Figur 2 ein DMS-Filter mit einem geteilten mittleren Wandler,

Figur 3 ein erfindungsgemäßes DMS-Filter, bei dem der Abstand zwischen den Teilwandlern vergrößert ist,

Figur 4 ein erfindungsgemäßes DMS-Filter, bei dem der Abstand zwischen den Teilwandlern durch ein Streifenmuster ausgefüllt ist,

Figur 5 ein erfindungsgemäßes DMS-Filter, bei dem zwei Wandler in durch ein metallisches Streifenmuster getrennte Teilwandler aufgeteilt sind,

Figur 6 eine Anordnung mit einem DMS-Filter, die eine Verschaltung von Resonatoren, Kapazitäten und Induktivitäten umfasst,

Figur 7 das Durchlassverhalten einer erfindungsgemäßen Filteranordnung im Vergleich zum Durchlassverhalten einer an sich bekannten Filteranordnung mit herkömmlichem DMS-Filter,

Figur 8 ein an sich bekanntes DMS-Filter mit neun Wandlern,

Figur 9 ein erfindungsgemäßes DMS-Filter mit ursprünglich neun Wandlern, von denen vier in Teilwandler aufgeteilt sind,

Figur 10 das Durchlassverhalten des in Figur 9 dargestellten erfindungsgemäßen DMS-Filters im Vergleich zum Durchlassverhalten des in Figur 8 dargestellten bekannten DMS-Filters,

Figur 11 ein erfindungsgemäßes DMS-Filter mit ursprünglich sieben Wandlern, von denen zwei in Teilwandler aufgeteilt sind.

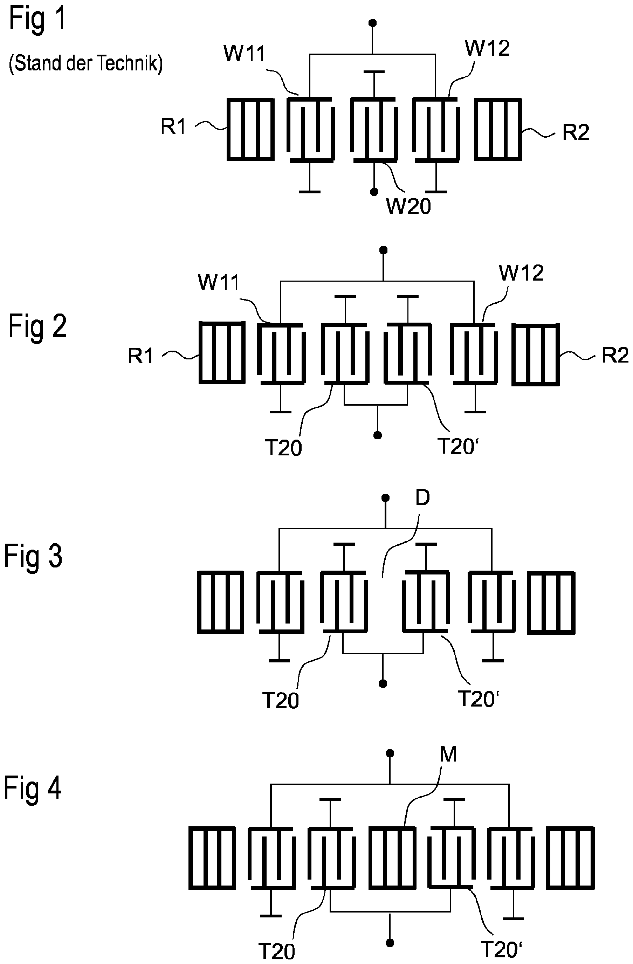

Figur 1 zeigt in schematischer Darstellung ein an sich bekanntes DMS-Filter mit drei Wandlern. Dieses umfasst zwischen einem ersten Reflektor R1 und einem zweiten Reflektor R2 zwei erste Wandler W11, W12, zwischen denen ein zweiter Wandler W20 angeordnet ist. Die ersten Wandler sind zueinander parallel geschaltet und beispielsweise mit dem Filtereingang gekoppelt. Der zweite Wandler W20 ist beispielsweise mit dem Filterausgang gekoppelt. Möglich ist es jedoch auch, die Zuordnung zu Ein- und Ausgang des DMS-Filters zu vertauschen.

Figur 2 zeigt eine erste einfache Ausführung eines DMS-Filters mit ursprünglich drei Wandlern. Im Unterschied zum Drei-Wandler-DMS gemäß Figur 1 ist der Wandler eines Typs, hier der zweite Wandler, in zwei Teilwandler T20, T20' aufgeteilt, die elektrisch parallel im Beispiel mit dem Ausgang des Filters verschaltet sind. Die ersten Wandler W11, W12 flankieren die beiden Teilwandler in herkömmlicher Weise. Wegen der Aufteilung in Teilwandler erhöht man die Gesamtanzahl der Elektrodenfinger für die gesamte Einheit aus erstem und zweitem Teilwandler T20, T20' gegenüber dem ungeteilten Wandler der bekannten DMS-Struktur. Der Abstand zwischen erstem und zweitem Teilwandler T20, T20' ist größer gewählt als ein Finger-Fingerabstand im Wandler und auch größer als die Abstände zwischen den Wandlern bekannter DMS-Filter.

Figur 3 zeigt ein erfindungsgemäßes DMS-Filter mit der gleichen Anzahl an Wandlern und Teilwandlern, bei dem jedoch der Abstand D zwischen den beiden Teilwandlern T20, T20' weiter vergrößert ist. Der Abstand D kann ein Mehrfaches des Abstands zwischen einem Teilwandler und dem direkt benachbarten "herkömmlichen" Wandler betragen.

Figur 4 zeigt ein weiteres erfindungsgemäßes DMS-Filter mit ursprünglich drei Wandlern und einem in Teilwandler T20, T20' geteilten mittleren Wandler, bei dem zwischen den beiden Teilwandlern T20, T20' eine Metallisierung M in Form eines metallischen Streifenmusters eingefügt ist. Das Streifenmuster ist wie ein herkömmlicher Reflektor ausgebildet, weist jedoch vorzugsweise eine geringere Anzahl an Reflektorstreifen auf, um eine akustische Durchlässigkeit zu gewährleisten. Die Funktionstüchtigkeit des erfindungsgemäßen DMS-Filters ist jedoch vom Grad der Durchlässigkeit des Streifenmusters der Metallisierung M, solange eine Durchlässigkeit überhaupt gegeben ist, weitgehend unabhängig.

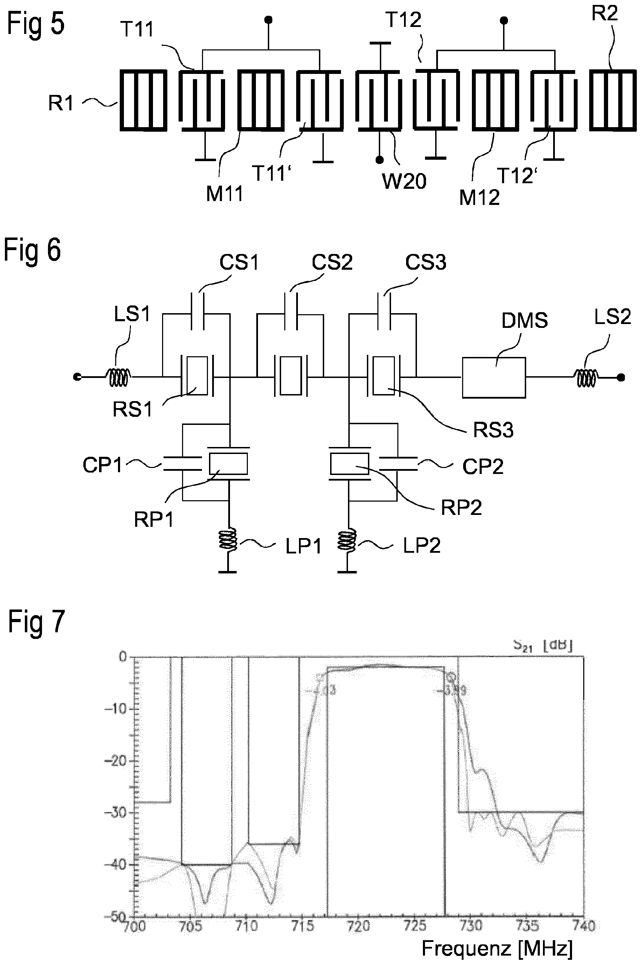

Figur 5 zeigt ein erfindungsgemäßes DMS-Filter mit ursprünglich drei Wandlern wie in Figur 1 dargestellt, bei dem die beiden ersten Wandler, die mit den in der Figur oben angeordneten Anschlüssen verbunden sind, in Teilwandler T11, T11' bzw. T12, T12' aufgeteilt sind. Der mittlere Wandler, der ein zweiter Wandler W20 ist, bleibt ungeteilt. Zwischen den Teilwandlern jedes der aufgeteilten ersten Wandler ist eine Metallisierung M11, M12 eingefügt, die wiederum als elektrisch kurzgeschlossenes Streifenmuster ausgebildet ist.

Die beiden Teilwandler eines aufgeteilten Wandlers sind jeweils elektrisch parallel geschaltet. Wie im herkömmlichen DMS-Filter können auch die beiden aufgeteilten ersten Wandler elektrisch parallel verschaltet werden, sodass sich ein single-ended Anschluss aus insgesamt vier parallel geschalteten Teilwandlern T11, T11', T12, T12' ergibt. Möglich ist es jedoch auch, die beiden aufgeteilten ersten Wandler mit einem symmetrischen Filteranschluss zu verbinden.

Figur 6 zeigt eine Anordnung, wie das erfindungsgemäße DMS-Filter mit weiteren Schaltungskomponenten, insbesondere mit Resonatoren, zu einer erweiterten Filteranordnung verbunden werden kann. Das DMS-Filter DMS ist nur schematisch dargestellt und kann unterschiedlich mit einer beliebigen Anzahl an geteilten und ungeteilten Wandlern ausgeführt sein. Erfindungsgemäße Filteranordnungen umfassen aber erfindungsgemäße DMS-Filter DMS, bei denen zumindest einer der Wandler in Teilwandler aufgeteilt ist. In einer Serienverschaltung mit dem DMS-Filter DMS sind drei Serienresonatoren RS1, RS2 und RS3 zwischen Ein- und Ausgang der Anordnung verschaltet. Parallel zu dieser Serienverschaltung sind zwei Parallelarme gegen Masse geschaltet, in denen jeweils ein Parallelresonator RP1, RP2 angeordnet ist.

Zumindest die Serienresonatoren RS sind jeweils parallel mit einer Kapazität CS verschaltet. Im dargestellten Ausführungsbeispiel sind auch die Parallelresonatoren RP mit einer Kapazität CP parallel verschaltet.

Ein- und ausgangsseitig ist die Serienverschaltung bzw. die Anordnung jeweils mit einer seriellen Spule LS1, LS2 verbunden, wobei die serielle Spule LS1 beispielsweise eingangsseitig, die serielle Spule LS2 ausgangsseitig angeordnet sein kann. Ein- und Ausgang der Anordnung können aber auch vertauscht sein.

Die Parallelzweige sind jeweils über eine Serieninduktivität LP1, LP2 mit Masse verbunden. Möglich ist es jedoch auch, beide Parallelzweige mit einer gemeinsamen Serieninduktivität parallel zu schalten und dann erst mit dem Masseanschluss zu verbinden.

Die in Figur 6 dargestellte Filteranordnung wird nun mit einem DMS-Filter gemäß Figur 5 realisiert und zum Vergleich mit einer entsprechenden Anordnung mit einer an sich bekannten DMS-Struktur gemäß Figur 1 verglichen.

Figur 7 zeigt die Übertragungsfunktion S21 der beiden Anordnungen, wobei die Kurve K1 einer erfindungsgemäßen Anordnung, die Kurve K2 jedoch der Anordnung mit dem bekannten DMS-Filter aus Figur 1 entspricht. Die Kurve K1 der erfindungsgemäßen Anordnung zeigt die stärksten Vorteile im Bereich der oberen Passbandflanke, die hier wesentlich steiler abfällt als die Kurve K2 der Anordnung mit dem bekannten DMS-Filter. Außerdem ist im nahen Sperrbereich die Dämpfung verbessert. Im Bereich des Passbandes zeigen beide Anordnungen fast das gleiche Verhalten, sodass die Kurven K1 und K2 dort geradezu deckungsgleich sind.

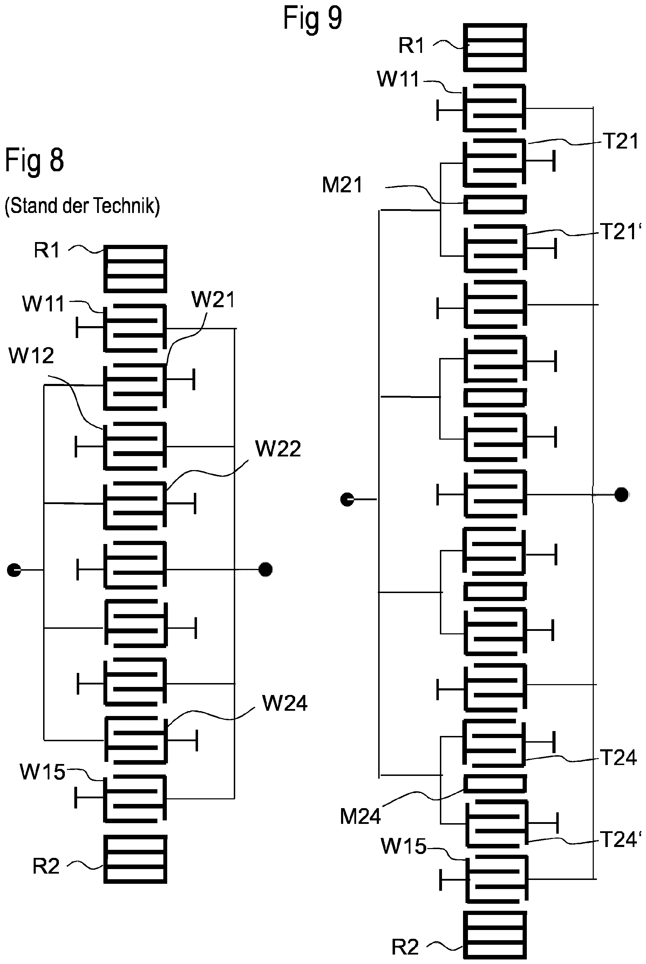

Figur 8 zeigt ein an sich bekanntes DMS-Filter mit neun Wandlern, bei dem fünf erste Wandler W11 bis W15 alternierend mit vier zweiten Wandlern W21 bis W24 zwischen zwei Reflektoren R1, R2 angeordnet sind. Sämtliche ersten Wandler können parallel mit einem Anschluss des Filters verbunden sein, während die vier zweiten Wandler ebenfalls parallel mit einem zweiten Anschluss des Filters verbunden sein können.

Figur 9 zeigt nun eine erfindungsgemäße Ausgestaltung eines solchen Neun-Wandler-DMS-Filters. Dazu sind sämtliche zweiten Wandler (W21 bis W24 aus Figur 8) in Teilwandler T21 bis T24 aufgeteilt, wobei zwischen jeweils zwei Teilwandlern T2 eine Metallisierung M2 angeordnet ist, die jeweils als Streifenmuster ausgebildet sein kann. Sämtliche Teilwandler T21 bis T24 können parallel mit einem Filteranschluss verbunden sein, ebenso sämtliche ersten Wandler W11 bis W15.

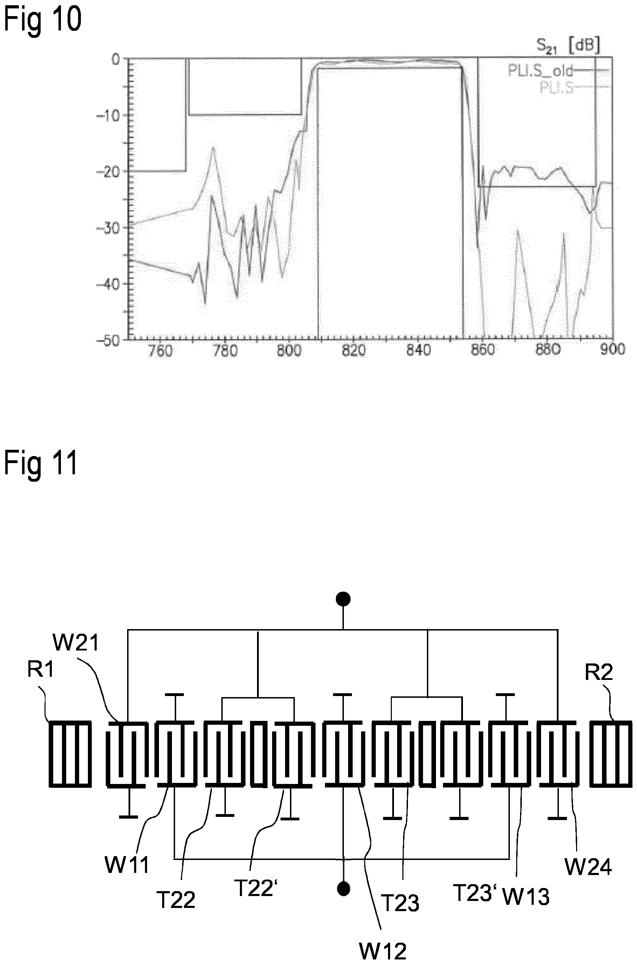

Auch das in Figur 9 dargestellte erfindungsgemäße DMS-Filter kann in einer Anordnung, wie beispielsweise in Figur 6 dargestellt, verschaltet sein. Figur 10 zeigt die Übertragungsfunktion einer solchen Anordnung im Vergleich mit derjenigen einer Anordnung, bei der Schaltelemente gemäß Figur 6 mit einem DMS-Filter gemäß Figur 8 verbunden sind. Die Kurve K1 zeigt die Filteranordnung mit dem DMS-Filter gemäß Figur 9, die Kurve K2 dagegen die Filteranordnung mit dem bekannten DMS-Filter nach Figur 8.

Auch hier zeigt sich die Verbesserung überwiegend im Bereich oberhalb des Passbandes und im nahen Sperrbereich. Die Selektion im nahen Sperrbereich ist stark verbessert. Bezüglich der Steilheit der rechten Flanke des Passbandes zeigen beide Kurven K1, K2 jedoch nur unwesentliche Unterschiede, da durch die hohe Anzahl an Wandlern im DMS-Filter in Verbindung mit den dazu verschalteten Resonatoren bereits entsprechend steile Flanken erzielt werden können.

Die sich zwischen je zwei Teilwandlern ausbildende Antiresonanz wird auf eine solche Frequenz gelegt, die einen zusätzlichen Dämpfungspol im nahen Sperrbereich erzeugt, der zu einem besseren Dämpfungsniveaus in diesem Bereich führt.

Es zeigt sich, dass mit den neuartigen DMS-Filtern stark verbesserte Filteranordnungen erhalten werden können, die den Einsatz dieser Filter in den modernen Kommunikationsstandards wie beispielsweise LTE ermöglichen. Die neuen Filteranordnungen können die dort gestellten Anforderungen an Bandbreite und Flankensteilheit gut erfüllen.

Obwohl die Erfindung insbesondere für breitbandige Filter und Filteranordnungen vorteilhaft ist, kann sie auch schmalbandig ausgeführten Filtern zum Vorteil gereichen. Auch schmale Passbänder müssen gegen benachbarte Bänder mit geringem Bandabstand isoliert werden. Auch das schmalbandige Filter muss eine entsprechende Selektion ermöglichen. Dies ist mit erfindungsgemäßen Anordnungen ebenfalls möglich.

Figur 11 zeigt eine weitere Variante eines DMS-Filters der erfindungsgemäßen Filteranordnung. Ausgehend von einem an sich bekannten DMS-Filter mit sieben Wandlern sind hier von den ursprünglich vier zweiten Wandlern W21 bis W24 nur die beiden mittleren zweiten Wandler W22, W23 in Teilwandler T22, T22' bzw. T23, T23' aufgeteilt. Die beiden äußeren zweiten Wandler W21 und W24 verbleiben ungeteilt. Zwischen je zwei aus einer Wandleraufspaltung hervorgehenden Teilwandlern kann ein teildurchlässiger Reflektor angeordnet sein, wie es auch in der Figur dargestellt ist.

Um auch mit diesen beiden äußeren zweiten Wandlern W21, W24 zusätzliche Antiresonanzen zu erzeugen, die zur Auslöschung des Signals bei einer Frequenz im nahen Sperrbereich führen, wird der Abstand der äußeren zweiten Wandler W21, W24 zum jeweils benachbarten Reflektor R1 bzw. R2 derart gestaltet, dass auch hier der gewünschte Effekt der Signalauslöschung für Frequenzen im nahen Sperrbereich eintritt.

Die zur Auslöschung führende phasenrichtige Signalüberlagerung tritt dann zwischen den vom Wandler erzeugten vom Reflektor weglaufenden und den vom gleichen Wandler in Richtung Reflektor abgestrahlten, von diesem aber wieder reflektierten Signalen auf. Mithin kann der gewünschte Effekt in der dargestellten Anordnung auch mit weniger Elektrodenfingern pro DMS Spur ausgeführt bzw. mit weniger aufgeteilten Wandlern erzielt werden. Auch mit dieser Anordnung wird ein Filter mit steilerer oberer Passbandflanke und einem verbesserten oberen Sperrbereich erhalten.

Möglich ist es natürlich auch, auch die beiden äußeren ersten Wandler W21 und W24 aufzuteilen.

Da die Erfindung nur anhand weniger Ausführungsbeispiele dargestellt werden konnte, ist sie nicht auf diese dargestellten Ausführungen beschränkt. Erfindungsgemäße Filteranordnungen können beliebig gestaltete DMS-Filter enthalten, sofern nur einer der Wandler in erfindungsgemäßer Weise aufgeteilt ist und gewünschte zusätzliche Antiresonanz aufweist, die zur Auslöschung von Signalen bei Frequenzen im nahen Sperrbereich dient.

Auch die Anzahl der mit einem solchen DMS-Filter in der Anordnung verschalteten Resonatoren ist nicht erfindungswesentlich, ebenso wenig deren Anordnung in der Verschaltung. Vorteilhaft kann es beispielsweise sein, nahe dem Filtereingang zunächst einen Parallelresonator vorzusehen und nicht, wie in Figur 6 dargestellt, einen Serienresonator.

Erfindungsgemäße Filteranordnungen können auf unterschiedlichen piezoelektrischen Substraten ausgebildet sein, vorzugsweise jedoch auf hochkoppelnden Substraten wie beispielsweise Lithiumniobat oder Lithiumtantalat. Schmalbandige erfindungsgemäße Filter können auch auf schwächer koppelnden Substraten ausgeführt sein, da die Vorteile der Erfindung unabhängig von der Kopplungsstärke des Substrats erzielt werden können.

Bezugszeichenliste

| | |
|---|---|
| R1, R2 | Reflektoren |
| W1 | Erste Wandler |
| W2 | Zweite Wandler |
| T, T' | Teilwandler |
| D | freie Abstand zwischen Teilwandlern |
| M | Metallisierung zwischen Teilwandlern |
| LS | Serielle Spule |
| LP | parallele Spule |
| RS | Serienresonator |
| RP | Parallelresonator |
| CS | Serielle Kapazität |
| CP | parallele Kapazität |
| DMS | DMS Filter |
| LP | Serieninduktivität |

**Patentansprüche**

1. Anordnung mit einem DMS Filter, enthaltend einen Ein- und Ausgang bei der das DMS Filter erste und zweite Wandler aufweist, die alternierend auf einem piezoelektrischen Substrat zwischen zwei Reflektoren angeordnet und wobei die ersten Wandler mit jeweils einem aus dem Ein- oder Ausgang der Anordnung verbunden sind, und wobei die zweiten Wandler mit dem jeweils anderen aus dem Aus- oder Eingang der Anordnung verbunden sind;

   bei der zumindest entweder die ersten Wandler oder die zweiten Wandler dergestalt sind, dass sie einen geteilten Wandler enthalten, der zwei symmetrisch angeordnete und elektrisch parallel geschaltete Teilwandler aufweist,
   wobei die Teilwandler gegeneinander um einen Betrag von zumindest etwa einer halben Wellenlänge so auseinander gerückt sind, dass sich deren Signale bei einer Frequenz in einem Stoppband gegenseitig auslöschen, und
   bei der der voneinander zugewandten Außenkanten von endständigen Elektrodenfingern der Teilwandler gemessene freie Abstand zwischen den beiden Teilwandlern mehr als eine Wellenlänge beträgt.

2. Anordnung nach Anspruch 1,
   bei der auf dem Substrat im freien Abstand zwischen den beiden Teilwandlern eine akustisch nicht-anregende Metallisierung angeordnet ist.

3. Anordnung nach einem der Ansprüche 1-2,
   bei der zwei und mehr Wandler eines Typs, ausgewählt aus erstem und zweitem Wandler vorhanden sind und bei der zwei oder mehr dieser Wandler dieses Typs die Merkmale des besagten geteilten Wandlers aufweisen.

4. Anordnung nach einem der Ansprüche 1-3,
   bei der das DMS Filter symmetrisch aufgebaut ist und eine ungerade Gesamtanzahl an ersten und zweiten Wandlern aufweist, bei der der oder die besagten geteilten Wandler von dem Typ ausgewählt aus ersten und zweiten Wandlern sind, dem auch die im DMS Filter äußeren Wandler zugeordnet sind, bei der außer den beiden äußeren Wandlern alle Wandler dieses Typs die Merkmale des besagten geteilten Wandlers aufweisen.

5. Anordnung nach einem der Ansprüche 1-4,
   weiter umfassend zumindest einen in Serie zum DMS Filter geschalteten Serienresonator und einen parallel dazu geschalteten Parallelresonator.

6. Anordnung nach Anspruch 5,
   bei der am Ein- und am Ausgang der Anordnung je eine Spule in Serie geschaltet ist.

7. Anordnung nach Anspruch 5 oder 6,
   bei der parallel zumindest zu jedem der Serienresonatoren eine Kapazität geschaltet ist.

8. Anordnung nach Anspruch 5-7,
   bei der der oder die Parallelresonatoren über je eine oder eine gemeinsame Serieninduktivität mit einem Masseanschluss verbunden sind.

9. Anordnung nach einem der Ansprüche 2-8, sofern sie sich auf Anspruch 2 beziehen,

   bei der die Metallisierung als elektrisch floatendes oder kurzgeschlossenes Streifenmuster ausgebildet ist,
   bei der jeweils bis zu n endständige Elektrodenfinger, Reflektorfinger oder Streifen des Streifenmusters in allen Bereichen, wo zwei Einheiten, ausgewählt aus Wandler, Reflektor und Streifenmuster einander direkt benachbart sind, eine gegenüber den übrigen Bereichen des jeweiligen Wandlers, Reflektors oder Streifenmusters abgesenkten Abstand aufweisen, wobei der Abstand von der Mitte des jeweiligen Fingers oder Streifens aus bemessen wird und wobei $3 \leq n \leq 12$ gewählt ist.

10. Anordnung nach einem der vorangehenden Ansprüche,
    bei der alle ersten Wandler parallel geschaltet sind.

11. Anordnung nach einem der vorangehenden Ansprüche,
    bei der alle zweiten Wandler parallel geschaltet sind.

12. Anordnung nach einem der vorangehenden Ansprüche,
    bei der die Wandler zumindest eines Typs, ausgewählt aus erstem und zweitem Wandler mit einem symmetrischen Tor verbunden sind.

**Claims**

1. An arrangement comprising a DMS filter, comprising an input and an output,

   - wherein the DMS filter comprises first and second transducers that are arranged in an alternating manner on a piezoelectric substrate between two reflectors and wherein the first transducers are each connected to one of an input or output of the arrangement, and wherein the second transducers are each connected to the corresponding other of output and input of the arrangement;

- wherein at least either the first or the second transducers are configured so that they comprise a divided transducer having two symmetrically arranged sub-transducers that are electrically connected in parallel,
- wherein the sub-transducers are shifted apart from each other by an amount of approximately half wavelength with respect to their original position in such a way that their signals cancel each other out at a frequency in a stopband, and wherein the open clearance between the two sub-transducers that is measured from the outer edges of terminal electrode fingers of the sub-transducers that face each other is more than one wavelength.

2. The arrangement according to claim 1, wherein an acoustically non-excitatory metallization is arranged on the substrate in the open clearance between the two sub-transducers.

3. The arrangement according to one of the claims 1-2, wherein the two or more transducers of a type selected from a first and second transducer are available and wherein the two or more of these transducers comprise the features of said divided transducer.

4. The arrangement according to one of the claims 1-3, wherein the DMS filter has a symmetric structure and an uneven total number of first and second transducers, wherein the said divided transducer(s) is/are of the type selected from first and second transducers, to which also the outer transducers in the DMS filter are assigned, wherein, except for the two outer transducers, all transducers of this type comprise the features of said divided transducer.

5. The arrangement according to one of the claims 1-4, further comprising at least one series resonator connected in series to the DMS filter and a parallel resonator thereto connected in parallel.

6. The arrangement according to claim 5, wherein one coil is connected in series at the input and one at the output of the arrangement, respectively.

7. The arrangement according to claims 5 or 6, wherein a capacitor is connected in parallel to each of the serial resonators.

8. The arrangement according to claims 5-7, wherein the parallel resonator(s) is/are connected via a series inductor each or via a common series inductor to a ground connection.

9. The arrangement according to one of the claims 2-8, as long as they refer to claim 2,

- wherein the metallization is designed as an electrically floating or short-circuited strip pattern,
- wherein in each case up to n terminal electrode fingers, reflector fingers or strips of the strip pattern in all regions where two units, selected from among transducers, reflectors and strip patterns, are directly adjacent to each other, have a reduced spacing compared to the remaining regions of the respective transducer, reflector or strip pattern, wherein the distance is measured from the center of the respective finger or strip out, and wherein $3 \leq n \leq 12$ is selected.

10. The arrangement according to one of the preceding claims, wherein all first transducers are connected in parallel.

11. The arrangement according to one of the preceding claims, wherein all second transducers are connected in parallel.

12. The arrangement according to one of the preceding claims, wherein the transducers of at least one type selected from first and second transducer are connected to a symmetrical gate.


**Revendications**

1. Ensemble avec un filtre DMS comprenant une entrée et une sortie, dans lequel le filtre DMS présente des premiers et des deuxièmes convertisseurs qui sont disposés en alternance sur un substrat piézoélectrique entre deux réflecteurs, et dans lequel les premiers convertisseurs sont reliés à une respective parmi l'entrée ou la sortie de l'ensemble, et dans lequel les deuxièmes convertisseurs sont reliés à l'autre respective parmi la sortie ou l'entrée de l'ensemble ;

dans lequel au moins soit les premiers convertisseurs soit les deuxièmes convertisseurs sont du type tel qu'ils contiennent un convertisseur divisé qui comprend deux convertisseurs partiels disposés de manière symétrique et montés électriquement en parallèle, dans lequel les convertisseurs partiels sont écartés l'un de l'autre d'une valeur d'au moins environ une demi-longueur d'onde de telle sorte que leurs signaux se neutralisent mutuellement à une fréquence dans une bande de coupure, et dans lequel la distance libre entre les deux convertisseurs partiels, mesurée entre les arêtes extérieures tournées les unes vers les autres des doigts d'électrode autonomes des convertisseurs partiels, est supérieure à une longueur d'onde.

**2.** Ensemble selon la revendication 1, dans lequel une métallisation non acoustiquement excitée est disposée sur le substrat à la distance libre entre les deux convertisseurs partiels.

**3.** Ensemble selon l'une des revendications 1 à 2, dans lequel il est prévu deux convertisseurs et plus d'un type choisi parmi le premier et le deuxième convertisseur et dans lequel deux convertisseurs ou plus desdits convertisseurs dudit type présentent les caractéristiques dudit convertisseur divisé.

**4.** Ensemble selon l'une des revendications 1 à 3, dans lequel le filtre DMS présente une structure symétrique et présente un nombre total impair de premiers et deuxièmes convertisseurs, dans lequel le ou lesdits convertisseurs divisés sont du type choisi parmi les premiers et deuxièmes convertisseurs, auquel les convertisseurs extérieurs dans le filtre DMS sont également associés, dans lequel hormis les deux convertisseurs extérieurs tous les convertisseurs dudit type présentent les caractéristiques dudit convertisseur divisé.

**5.** Ensemble selon l'une des revendications 1 à 4, comprenant par ailleurs au moins un résonateur en série branché en série par rapport au filtre DMS et un résonateur parallèle branché en parallèle par rapport à celui-ci.

**6.** Ensemble selon la revendication 5, dans lequel une bobine est branchée respectivement en série sur l'entrée et sur la sortie de l'ensemble.

**7.** Ensemble selon la revendication 5 ou 6, dans lequel un condensateur est branché en parallèle au moins par rapport à chacun des résonateurs en série.

**8.** Ensemble selon l'une des revendications 5 à 7, dans lequel le ou les résonateurs parallèles sont reliés à une borne de masse par l'intermédiaire de respectivement ou une inductance de série commune.

**9.** Ensemble selon l'une des revendications 2 à 8, dans la mesure où elles se rapportent à la revendication 2,

dans lequel la métallisation est réalisée en un motif en bande électriquement flottant ou court-circuité ;
dans lequel jusqu'à n doigts d'électrode autonomes, doigts de réflecteur ou bandes du motif de bande présentent respectivement dans toutes les zones où deux unités choisies parmi le convertisseur, le réflecteur et le motif de bande sont directement adjacentes l'une à l'autre, une distance diminuant par rapport aux autres zones du convertisseur, réflecteur ou motif de bande respectif, la distance du centre du doigt respectif ou de la bande respective étant ajustée, et n étant choisi $3 \leq n \leq 12$.

**10.** Ensemble selon l'une des revendications précédentes, dans lequel les premiers convertisseurs sont tous branchés en parallèle.

**11.** Ensemble selon l'une des revendications précédentes, dans lequel les deuxièmes convertisseurs sont tous branchés en parallèle.

**12.** Ensemble selon l'une des revendications précédentes, dans lequel les convertisseurs d'au moins un type choisi parmi le premier et le deuxième convertisseur sont reliés à une porte symétrique.

Fig 1

(Stand der Technik)

Fig 2

Fig 3

Fig 4

Fig 5

R1 — T11 — T12 — R2
M11 — T11' — W20 — M12 — T12'

Fig 6

CS1  CS2  CS3

LS1  DMS  LS2

RS1  RS3

CP1  RP1  CP2

RP2

LP1  LP2

Fig 7

$S_{21}$ [dB]

Frequenz [MHz]

## Fig 9

## Fig 8

(Stand der Technik)

R1

W11        W21

W12

W22

W24

W15

R2

R1

W11

T21

M21

T21'

W24

T24

M24

W15

T24'

R2

Fig 10

Fig 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 09148873 B